Europäisches Patentamt

European Patent Office

Office européen des brevets

(11) Veröffentlichungsnummer: **0 364 962**
**A1**

## (12) EUROPÄISCHE PATENTANMELDUNG

(21) Anmeldenummer: **89119272.6**

(22) Anmeldetag: **17.10.89**

(51) Int. Cl.⁵: **H05K 3/34**

(30) Priorität: **19.10.88 DE 3835650**

(43) Veröffentlichungstag der Anmeldung:
**25.04.90 Patentblatt 90/17**

(84) Benannte Vertragsstaaten:
**AT BE CH DE FR GB IT LI NL**

(71) Anmelder: **Siemens Aktiengesellschaft**
**Wittelsbacherplatz 2**
**D-8000 München 2(DE)**

(72) Erfinder: **Degle, Walter, Dipl.-Ing.**
**Entenweg 3**
**D-8903 Bobingen(DE)**
Erfinder: **Müller, Helmut, Dipl.-Ing.**
**Paul-Lincke-Strasse 26**
**D-8900 Augsburg(DE)**

(54) **Anordnung zur Temperaturüberwachung beim Schwallöten von Flachbaugruppen.**

(57) Die Erfindung bezieht sich auf eine Anordnung zur Temperaturüberwachung beim Schwallöten von Flachbaugruppen. Durch das Schwallöten können Flachbaugruppen überhitzt werden, so daß Ausfälle entstehen. Dieses Problem löst die Erfindung dadurch, daß unmittelbar nach der Schwalldüse (1) ein mit einem Blech (3) vom Lötschwall und nach oben abgeschirmtes Pyrometer (2) quer zur Lötrichtung und schräg nach oben gegen die zu lötende Flachbaugruppe (4) gerichtet, angeordnet ist, daß das Pyrometer mit einem Grenzwertgeber verbunden ist, der bei Überschreiten des Grenzwertes anspricht.

EP 0 364 962 A1

## Anordnung zur Temperaturüberwsachung beim Schwallöten von Flachbaugruppen

Die Erfindung betrifft eine Anordnung zur Temperaturüber*achung beim Schwallöten von Flachbaugruppen.

Beim Schwallöten ist ein Überhitzen von Flachbaugruppen nicht absolut auszuschließen. Funktionsausfälle sind die Folge. Dieser Zustand kann bei parametergesteuerten, als auch bei konventionellen starren Lötanlagen auftreten. Ursachen hierfür können sein, daß die steuerbaren Parameter falsch festgelegt, feste Parameter falsch eingerichtet, ein falsches Lötprogramm eingeschaltet ist oder Steuerfehler auftreten. Es können auch die Parameter in der zulässigen Toleranz, jedoch alle im äußersten Plusbereich liegen.

Aufgabe der vorliegenden Erfindung ist es, eine Anordnung zu schaffen, durch die das Überhitzen von Flachbaugruppen beim Löten vermieden wird.

Zur Lösung dieser Aufgabe wird die Anordnung gemäß der Erfindung derart ausgebildet, daß unmittelbar nach der Schwalldüse ein mit einem Blech vom Lötschwall nach oben abgeschirmtes Pyrometer quer zur Lötrichtung und schräg nach oben gegen die zu lötende Flachbaugruppe gerichtet angeordnet ist, daß das Pyrometer mit einem Grenzwertgeber verbunden ist, der bei Überschreiten einer zulässigen Grenztemperatur der Flachbaugruppe anspricht.

Dabei kann bei Überschreiten des zulässigen Grenzwertes der Temperatur eine Alarmeinrichtung, z.B. in Form einer Meldelampe oder eine Sicherheitsvorrichtung, z.B . zum Stoppen der Anlage, betätigt werden. Es ist auch möglich, damit die Parameter, z.B. die Lötgeschwindigkeit, zu beeinflussen.

Durch diese Maßnahmen wird erreicht, daß Funktionsausfälle von Flachbaugruppen verringert werden, wodurch weniger Nacharbeit und weniger Verwurf teurer Baugruppen entsteht.

Anhand des Ausführungsbeispiels wird die Erfindung näher erläutert. Über eine Schwalldüse 1 wird die mit elektronischen Bauteilen bestückte Flachbaugruppe 4 zum Zwecke des Festlötens der Bauelemente geführt. Unterhalb der Flachbaugruppe ist ein Pyrometer 2 angeordnet, das quer zur Bewegungsrichtung und schräg nach oben zur Flachbaugruppe hin ausgerichtet ist. Um die Strahlungseinwirkung zu verringern, die Umgebungstemperatur des Pyrometers auf notwendige 35°C zu beschränken und zugleich das Pyrometer vor Lotspritzern zu bewahren, ist das Schirmblech 3 vorgesehen, das das Pyrometer nach oben und zur Seite des Lötschwalls hin abdeckt. Um Verschmutzungen des Strahlungsempfängers des Pyrometers zu vermeiden, kann um das Pyrometer herum eine

Luftspülung vorgesehen werden.

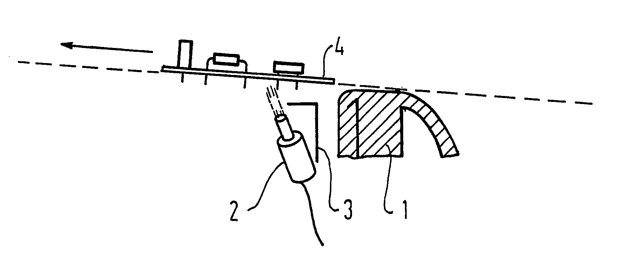

### Ansprüche

1. Anordnung zur Temperaturüberwachung beim Schwallöten von Flachbaugruppen, **dadurch gekennzeichnet,** daß unmittelbar nach der Schwalldüse (1) ein mit einem Blech (3) vom Lötschwall nach oben abgeschirmtes Pyrometer (2) quer zur Lötrichtung und schräg nach oben gegen die zu lötende Flachbaugruppe gerichtet angeordnet ist, daß das Pyrometer mit einem Grenzwertgeber verbunden ist, der bei Überschreiten einer zulässigen Grenztemperatur der Flachbaugruppe anspricht.

2. Anordnung zum Temperaturüberwachen beim Schwallöten von Flachbaugruppen nach Anspruch 1, **dadurch gekennzeichnet,** daß bei Überschreiten des zulässigen Grenzwertes eine Signaleinrichtung, z.B. eine Meldelampe anspricht.

3. Anordnung zum Temperaturüberwachen beim Schwallöten von Flachbaugruppen nach Anspruch 1, **dadurch gekennzeichnet,** daß bei Überschreiten des zulässigen Grenzwertes der Temperatur eine Sicherheitsvorrichtung, z.B. eine Anlagenstopvorrichtung betätigt wird.

4. Anordnung zum Temperaturüberwachen beim Schwallöten von Flachbaugruppen nach Anspruch 1, **dadurch gekennzeichnet,** daß beim Überschreiten des zulässigen Grenzwerts der Temperatur prozeßrelevante Paramter, z.B. die Lötgeschwindigkeit, beeinflußt werden.

Europäisches
Patentamt

# EUROPÄISCHER RECHERCHENBERICHT

Nummer der Anmeldung

| | | | | |
|---|---|---|---|---|
| **EINSCHLÄGIGE DOKUMENTE** | | | | EP 89119272.6 |

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP - A1 - 0 279 011 (ELECTROVEST) * Zusammenfassung; Fig. 1-13; Patentansprüche 1-21 * -- | 1-4 | H 05 K 3/34 |
| A | EP - A1 - 0 118 091 (ELECTROVEST) * Zusammenfassung; Fig. 1,2; Patentansprüche 1-10 * -- | 1-4 | |
| A | EP - A1 - 0 269 822 (ELECTROVEST) * Zusammenfassung; Fig. 1-7 * ---- | 1-4 | |

**RECHERCHIERTE SACHGEBIETE (Int. Cl.4)**

H 05 K 3/00
H 01 R 43/00

Der vorliegende Recherchenbericht wurde für alle Patentansprüche erstellt.

| Recherchenort | Abschlußdatum der Recherche | Prüfer |
|---|---|---|
| WIEN | 27-12-1989 | VAKIL |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82